Europäisches Patentamt

European Patent Office

Office européen des brevets

(11) Publication number: **0 208 459 B1**

## EUROPEAN PATENT SPECIFICATION

(45) Date of publication of patent specification: **18.03.92**

(51) Int. Cl.[5]: **H01L 21/316, C23C 16/40**

(21) Application number: **86304844.3**

(22) Date of filing: **24.06.86**

(54) Process for the chemical vapour deposition of a thin film of oxide on a silicon wafer.

(30) Priority: **24.06.85 US 748090**

(43) Date of publication of application:
**14.01.87 Bulletin 87/03**

(45) Publication of the grant of the patent:
**18.03.92 Bulletin 92/12**

(84) Designated Contracting States:
**DE FR GB IT NL**

(56) References cited:
**EP-A- 0 139 134**
**US-A- 3 934 060**

**JOURNAL OF THE ELECTROCHEMICAL SOCI-
ETY, vol. 126, no. 6, June 1979, pages
1042-1046, Princeton, New Jersey, US; A.C.
ADAMS et al.: "The deposition of silicon
dioxide films at reduced pressure"**

**EXTENDED ABSTRACTS, vol. 82-2, October
1982, pages 305-306, abstract no. 193, Pen-
nington, New Jersey, US; R.H. VOGEL et al.:
"Electrical properties of 200-500A LPCVD
SiO2 films"**

**MATERIALS LETTERS, vol. 1, no. 1, June
1982, pages 29-32, North-Holland, Amster-
dam, NL; R.M. LEVIN et al.: "The step cov-
erage of CVD SiO2 glass films"**

**JOURNAL OF THE ELECTROCHEMICAL SOCI-
ETY, vol. 115, no. 6, June 1968, pages
649-6652, Princeton, New Jersey, US; J.
OROSHNIK et al.: "Pyrolytic deposition of
silicon dioxide in an evacuated system"**

(73) Proprietor: **Silicon Valley Group, Inc.
541 East Trimble Road
San Jose, CA 95131(US)**

(72) Inventor: **Sargent, Diane J.
5251 Berkeley Avenue
Westminister California 92683(US)**
Inventor: **Fisk, Michael J.
953 David Street
Anaheim California 92803(US)**
Inventor: **Goldman, Jon C.
2156 North Shaffer
Orange California 92665(US)**

(74) Representative: **Harrison, David Christopher
et al
MEWBURN ELLIS 2 Cursitor Street
London EC4A 1BO(GB)**

**Description**

This invention relates to a process for the chemical vapour deposition of a thin film of oxide, particularly silicon dioxide, on a silicon wafer.

The development of semiconductor devices, and in particular integrated circuits, has been notable for the continuing increase in performance of commercially available semiconductor devices. One of the reasons for this continuing increase in performance has been the ability of the industry to control to ever narrower tolerances the individual variables associated with the numerous processes required to manufacture integrated circuit devices. This invention relates to an improvement in a low pressure chemical vapour deposition (CVD) process for depositing silicon dioxide on silicon wafers from a vapourised liquid source reactant. One such source reactant is tetraethoxysilane [$(C_2H_5O)_4Si$)], which is also known as tetraethylorthosilicate. In the semiconductor field, this reactant is generically known by its acronym TEOS and a deposition process utilising TEOS as a reactant is known as a TEOS process.

A low pressure CVD TEOS process is disclosed in U.S. Patent No. 3,934,060 to Burt et al. for METHOD FOR FORMING A DEPOSITED SILICON DIOXIDE LAYER ON A SEMICONDUCTOR WAFER. Similar processes are disclosed by A.C. Adams et al., J. Electrochemical Society, Vol. 126, No. 6, p. 1042 (June 1979) and Oroshnik et al., J. Electrochemical Society, Vol. 115, No. 6, p. 649 (June 1968). Burt et al. disclose that low pressure are advantageously utilised to obtain uniform film thicknesses and to achieve adherent dense films having relatively few impurities. One of the drawbacks of the process according to US-A-3 934 060, however, lies in the fact that TEOS is a liquid at room temperature (25°C.) and pressure (760 torr). Accordingly, it is necessary, as Burt et al. disclose to vapourise the TEOS liquid by heating it. There are specially designed TEOS vapour generators commercially available for that purpose. The problem with such an arrangement is that the delivery of the TEOS vapour to a deposition chamber cannot be metered or controlled.

It has also been found in the TEOS process according to US-A-3934060 that unsteady flows of TEOS vapour rather than a uniform vapour flow may be emitted from a TEOS generator. As vapour is generated, it carries away a quantity of thermal energy and the instantaneous generation of relatively large quantities of TEOS vapour causes the vapourisation of additional TEOS vapour from the liquid state to be reduced temporarily until additional thermal energy can be transferred to the remaining TEOS liquid from a surrounding heater. As a result of these variations in the rate of delivery of the TEOS vapour, wafer fabricators have had to be satisfied with thickness variations of deposited silicon dioxide films on silicon wafers of 8% to 9% along the length of a boat carrying the silicon wafers within the deposition chamber. And most importantly, none of the aforementioned prior art processes have proven consistent deposition rates run-to-run.

It is conventional in the process art to control a flow of a process gas such as hydrogen, oxygen or nitrogen to a deposition chamber with a mass flow controller or other mass flow metering devices. It is impracticable to control the flow of TEOS vapour because flow controllers operating on a thermal bridge principle working in conjunction with a solenoid valve are not sensitive enough to properly respond to the available pressure drop, which is less than the difference between the TEOS vapour pressure at 90°C and the operating pressure in the deposition chamber. Practical use of a controller would require the total pressure of the TEOS stream to be increased by using an inert carrier gas as is disclosed in U.S. Patent No. 4,517,220 to Rose, but this would dilute the reactant gas. Alternatively, it is theoretically possible, although undesirable, to increase the TEOS temperature to very high levels.

This invention aims to provide an improved low pressure CVD process for consistently depositing on silicon wafers a uniform silicon dioxide film within closer tolerances from a liquid source reactant such as TEOS and to enable more consistent deposition rates to be achieved.

The present invention provides a process for the chemical vapour deposition of a thin film of deposited oxide on at least one silicon wafer characterised in comprising the steps of: placing at least one silicon wafer in a deposition chamber; evacuating said deposition chamber to a subatmospheric pressure with a means for vacuum pumping; heating said wafer; flowing an inert gas into a means connecting said deposition chamber with said means for vacuum pumping for establishing a first vacuum level in said deposition chamber; vapourising a liquid source reactant; flowing said vapourised reactant into said deposition chamber while maintaining a second vacuum level in the deposition chamber; and contacting said silicon wafer with said vapourised source reactant to deposit a thin film of oxide on said silicon wafer.

Preferably the inert gas is nitrogen and the liquid source reactant is tetraethoxysilane (TEOS).

We have found the step of flowing inert gas into the process downstream of the silicon wafer(s) to be particularly useful in controlling the flow of the TEOS vapour. We have also found however that such a control scheme leads to gradually deteriorating process conditions over the life of the process equipment when a reactant such as TEOS is utilised.

The invention also contemplates an improved process for calibrating the CVD system before depositing the film on the wafers for maintaining the same system operating parameters from run to run, particularly the operating pressure (i.e. the second vacuum level in the above process) and reactant gas flow rate, notwithstanding the deterioration of the process. This aspect of the process generally comprises the steps of evacuating the deposition chamber by the vacuum pump, flowing the inert gas into the vacuum pump at a first flow rate for establishing the preselected second vacuum level, determining a second inert gas flow rate from the difference between the first inert gas flow rate and the preselected reactant gas flow rate, flowing inert gas into the process downstream of the deposition chamber at the second inert gas flow rate, flowing reactant gas into the deposition chamber at the preselected flow rate, and then contacting the silicon wafers with reactant gas to deposit thin films on the wafers. Of course, the total process includes the conventional steps of purging, heating, backfilling and the like, although our invention per se does not include such steps. Recalibration of the system as described allows consistent operating conditions from run to run as long as the first inert gas rate exceeds the second inert gas rate. As the first inert gas rate begins to approach the reactant gas rate, the system must be taken off-line and cleaned out.

The invention will be more particularly described with reference to the accompanying drawings which show a presently preferred embodiment thereof.

In the accompanying drawings:

Figure 1 is a schematic diagram of apparatus for carrying out the inventive low pressure CVD process utilising a liquid source such as TEOS; and

Figure 2 is a graph disclosing a relationship of pumping pressure of a vacuum pump to gas flow rate through a system to which it is connected and the degradation in pumping capacity through a low pressure CVD apparatus used for depositing silicon dioxide.

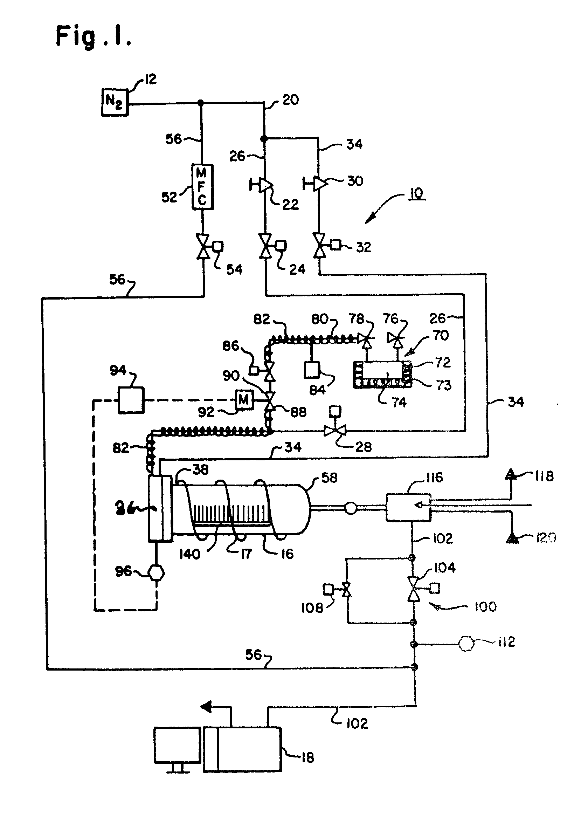

Referring now to the drawings, and especially Figure 1, the system for carrying out the inventive process comprises apparatus generally indicated by numeral 10 and includes a source of nitrogen 12, and a liquid source 70 of a reactant such as TEOS which are connected to a deposition chamber such as quartz deposition tube 16 in order to supply, respectively, nitrogen and TEOS vapour to the elongated horizontal quartz deposition tube 16. A conventional electric resistance heater 17 comprised of one or more heater sections is helically wrapped around the quartz deposition tube 16 and is connectable to a source of electric power for energisation thereby. A vacuum pump 18 is also connected to the quartz deposition tube 16 to reduce the pressure therein.

The nitrogen source 12 is a pressurised nitrogen tank or the like which is connected to a nitrogen delivery line 20 which then branches into delivery lines 26, 34 and 56. Generally speaking, backfill line 34 and purge line 26 provide nitrogen to the system for purging air, reactants, byproduct gases and/or backfilling both before and after the deposition step. Ballast line 56 provides nitrogen for ballasting the CVD process during the deposition step.

The backfill line 34 has a needle valve 30 connected thereto followed downstream by a normally open shutoff valve 32. Line 34 extends to door 36 at the load end 38 of the quartz deposition tube 16.

The purge line 26 has a needle valve 22 connected thereto followed downstream by a normally closed shutoff valve 24. Line 26 extends to TEOS supply line 80 and has valve 28 near the connection. Line 80 extends to door 36 at the load end 38 of the quartz deposition tube 16.

The nitrogen ballast line 56 has a mass flow controller 52 connected thereto followed downstream by a normally closed shutoff valve 54 for supplying dry nitrogen to the process downstream of the silicon wafers. As is illlustrated, the ballast line is connected to exhaust line 102 which connects the exhaust end 58 of the quartz deposition tube 16 to the vacuum pump 18. The mass flow controller may be any suitable commercially available controller. In the demonstration tests described herein, a one slm controller was advantageously used.

A TEOS supply system, generally identified by numeral 70, is connected to the load end 38 of the quartz deposition tube 16. The TEOS delivery system 70 includes a TEOS vapouriser 72, of conventional bubbler design, having a heating element 73 wrapped around a vessel 74 containing TEOS liquid. The vessel 74 has an input port 76 and an output port 78 connected thereto. The input port 76 is only used if a carrier gas is supplied, which is not the case in the instant embodiment. The output port 78 is connected to a TEOS supply line 80 to deliver TEOS vapour thereto.

The TEOS vapouriser has a temperature controller (not shown) for maintaining the TEOS in the TEOS vessel at a constant temperature. A heating tape 82 is wound around the TEOS supply line 80 to prevent the TEOS vapour flowing therein from condensing. A temperature controller 84 is connected to the heating tape 82 to maintain the TEOS supply line 80 at a constant preselected temperature. The temperature can be controlled at any suitable point. In the presently described apparatus, the temperature was controlled in a range of from about 40°C to 80°C (with the vapour pressure of TEOS varying from about 7 to 40 torr). A normally closed air valve 86 is connected in line 80 for isolating the TEOS system 70 from the diffusion tube 16.

A TEOS flow control valve 88 is connected in line 80 downstream of shutoff valve 90. Preferably valve 90 is a plug valve. The valve comprises a valve body 90 and a motor driver 92 operatively connected to a pressure controller 94 which in turn is connected to a pressure sensor 96 in the door assembly 36 of the diffusion tube 16. The pressure sensor may be any suitable commercially available device such as, e.g., a capacitance manometer. Thus, in the embodiment illustrated by Figure 1, the pressure controller controls the pressure in the diffusion tube by controlling the TEOS flow through valve 88. Also the pressure controller 94 prevents the TEOS from being delivered to the quartz deposition tube 16 until the tube 16 has been evacuated to a subatmospheric pressure.

A vacuum system 100 is connected to the exhaust end 58 of the quartz deposition tube 16 for maintaining the quartz deposition tube 16 at subatmospheric pressure during processing. The exhaust system 100 includes an exhaust line 102 connectively linking the exhaust end 58 of the quartz deposition tube 16 with a vacuum pump 18. Any suitable commercially available vacuum pump 18 may be used. In the demonstration tests described herein, a 50 cfm vacuum pump capable of pulling a vacuum of 10 millitorr was utilised.

As is illustrated in Figure 1, a water cooled trap 116 having a water inlet 118 and outlet 120 may be connected in exhaust line 102 downstream of the diffusion tube 16 for preventing glassy materials and other debris from the TEOS diffusion step from reaching the vacuum pump 18. The trap 116 may be located at any location in line 102 but the illustrated location is preferred to prevent glassy materials from clogging the various valves and pressure sensors downstream of the deposition chamber 16. Downstream of trap 116 is an air operated full gate valve 104 in parallel with an air operated half gate valve 108. Generally speaking, the full gate valve 104 is used during the deposition and evacuation steps and the half gate valve 108 is initially used to permit a soft pump down of the deposition tube 16 to about one torr. Downstream of valve 104 are a pressure sensor 112, which may be a capacitance manometer for sensing the vacuum level in line 102, and the above-mentioned connection with nitrogen ballast line 56.

The above described system enables the process operating parameters, including total deposition pressure, TEOS temperature and vapour flow rate, to be closely controlled so that the film deposited on the wafers is uniform. Also, the system may be periodically recalibrated to maintain uniformity from run to run. In the operation of the above described system to deposit a thin oxide film from TEOS vapour onto a silicon wafer, at least one silicon wafer and preferably one hundred or more silicon wafers, are placed in the deposition tube 16. The wafers are usually loaded on-end in a standard boat 140 with their faces substantially parallel to each other and perpendicular to the long axis of the boat 140. The loaded boat 140 is then placed into the deposition tube 16 which has been heated by heater 117 to a suitable temperature for decomposing the TEOS, which may be from about 700°C to 740°C in this process. The tube is then closed and evacuated by vacuum pump 18 to a pressure of about 10 millitorr. The half gate valve 108 is initially used to obtain a soft pump down and the full gate valve 104 is then used during the remainder of the operation. A low flow of dry nitrogen is then introduced through purge line 26 into the load end 36 of the deposition tube 16 for a short period of time sufficient to purge air and reactive gases from the system and bring the wafer boat and wafers up to the process temperature. The temperature in the diffusion tube 16 is usually ramped between about 5°C to 30°C to compensate for depletion effects of the TEOS vapour as it flows down the tube 16.

After the loaded boat 140 has been placed in the deposition tube 16 and the other preliminary steps described above have been performed, the flow of dry nitrogen is stopped and the deposition tube 16 is evacuated by the vacuum pump 18 and the system is then pumped down to an initial level of about 10 millitorr. The deposition steps of the process may then be performed.

Nitrogen valve 54 is opened to permit ballast nitrogen to flow through the mass flow controller 52 in line 56 into the process downstream of the deposition tube 16 for establishing a vacuum level in the deposition tube 16. As will be explained below, the pumping speed of pump 18 deteriorates with use and it is preferable to recalibrate the system before each run to account for any changes caused by the preceding runs.

The TEOS system 70 is maintained at a suitable temperature for vapourising the TEOS liquid and preventing condensation of the TEOS vapour as it flows to the deposition tube 16. After the nitrogen ballast flow has been established, the TEOS shutoff valve 86 is opened and the vacuum level in the deposition tube causes a precalculated amount of the TEOS vapour to flow through control valve 88 into the deposition tube 16. The valve 88 controls the TEOS vapour flow to maintain a desired operating vacuum level in the deposition tube during the deposition step.

After the deposition run has been completed the nitrogen ballast valve 54 and TEOS shutoff valve 86 and TEOS control valve 88 are shut off and nitrogen purge valve 24 is opened for purging the system of the residual TEOS vapour and other vapours and gases. Because the purging nitrogen should not entrain debris which might contaminate the wafers, the nitrogen pressure in the deposition chamber should not exceed about 500 millitorr. After several minutes, the purge valve 24 is closed and, optionally, the system may be again pumped down to a pressure of about 10 millitorr. The full gate valve 104 is then closed and the system is backfilled with nitrogen through backfill line 34 and the diffusion tube 16 is then opened and the boat removed.

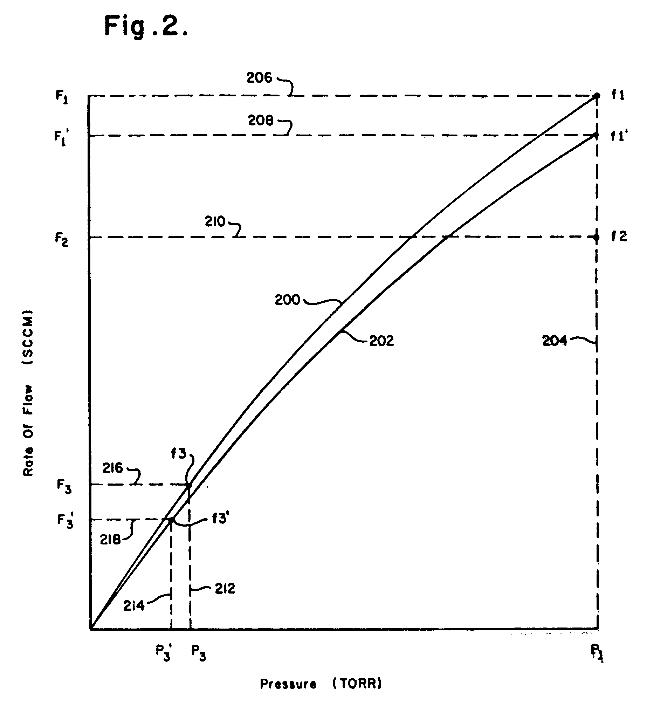

As stated above, and as can be best seen from Figure 2, it is important to periodically perform a system calibration because the pumping capacity (unit volume per unit time) of the system degrades. Most preferably, the system is recalibrated before each process run. Also the recalibration can be performed before or after the boat 140 is loaded into the deposition tube 16. Figure 2 shows that the pumping capacity of a system is a function of the vacuum level. Uppermost curve 200 shows the capacity/pressure relationship for a clean system. Vertical line 204 represents the desired system operating pressure $P_1$ during the deposition step. The intersection of curve 200 and line 204 at point $f_1$ determines the total pumping capacity at a pressure of $P_1$. The horizontal line 206 extending from point $f_1$ to the axis indicates that the total pumping capacity is $F_1$. The horizontal line 210 extending from point $F_2$ to point $f_2$ represents the desired TEOS vapour flow rate. The line may be either the actual TEOS vapour rate or an equivalent rate of nitrogen which reflects the particular operation's characteristics and the experience with it. The nitrogen ballast flow $F_3$ is then determined by the difference between the total capacity $F_1$ and the TEOS vapour rate $F_2$.

After one or more runs, the system degrades and curve 200 no longer is representative of the pumping capacity of the system. Rather lower curve 202 characterises the system and the intersection with vertical line 204 at point $f'_1$ indicates that the capacity of the system at a desired pressure $P_1$ has decreased. Extending horizontal line 208 from point $f'_1$ to the axis indicates that the capacity of the system is $F'_1$. Because the TEOS vapour rate is a constant $F_2$, the ballast nitrogen flow rate must be reduced to a flow rate $F'_3$ which is the difference between the total flow rate $F'_1$ and the TEOS vapour rate $F_2$.

The equipment described above was utilised in several runs of about 100 four inch silicon wafers per run which demonstrates the process and certain advantages over the Burt TEOS process. In a test of the Burt TEOS process wherein only the TEOS temperature was controlled (between 55°C and 70°C) the TEOS temperature varied ± 10°C and the deposition rate varied from 15.8 nm/min (158 angstroms/minute) to 18.4 nm/min (184 angstroms/minute).

In a first series of tests on four inch diameter wafers demonstrating the process illustrated in Figure 1, the TEOS temperature was controlled at about 65°C and the pressure $P_1$ in the deposition chamber was calibrated at 800 millitorr by flowing 854 sccm of dry nitrogen. A dry nitrogen flow $F_2$ of 646 sccm representing the desired TEOS vapour flow was subtracted from the total flow $F_1$ to determine the desired flow rate of ballast nitrogen $F_3$ in line 56, which was 208 sccm and corresponded to a pressure $P_3$ of 320 millitorr. Having calibrated the system, the CVD process was run using 208 sccm nitrogen ballast in line 56 and 646 sccm of TEOS vapour while maintaining the total process pressure at 800 millitorr.

The process, including the recalibration procedure, was repeated six times. The following calibration check before the second run indicated that there had been a slight degradation:

|  | 1st Run | 2nd Run |
| --- | --- | --- |
| Total flow (SCCM) | 854 | 844 |
| TEOS flow (SCCM) | 646 | 646 |
| $N_2$ flow (SCCM) | 208 | 198 |
| Total pressure (millitorr) | 800 | 800 |
| Ballast $N_2$ pressure (millitorr) | 320 | 318 |

The uniformity of the films deposited on wafers disposed in the boat on quarter inch centres down-the-boat and run-to-run was excellent, with deviations ranging ± 2.4% for all seven runs. The average deposition rate was 16.17 nm/min (161.7 angstroms/min). (±1.3%) for all seven runs.

**Claims**

1. A process for the chemical vapour deposition of a thin film of deposited oxide on at least one silicon wafer characerised in comprising the steps of: placing at least one silicon wafer in a deposition

EP 0 208 459 B1

chamber (16); evacuating said deposition chamber to a subatmospheric pressure with a means (18) for vacuum pumping; heating said wafer; flowing an inert gas into a means (102) connecting said deposition chamber (16) with said means (18) for vacuum pumping for establishing a first vacuum level in said deposition chamber (16); vapourising a liquid source reactant; flowing said vapourised reactant into said deposition chamber (16) while maintaining a second vacuum level in the deposition chamber (16); and contacting said silicon wafer with said vapourised source reactant to deposit a thin film of oxide on said silicon wafer.

2. A chemical vapour deposition process according to claim 1, wherein the second vacuum level in the deposition chamber is maintained by controlling the flow of vapourised reactant.

3. A chemical vapour deposition process according to claim 1 or 2, wherein the liquid source reactant is tetraethoxysilane.

4. A chemical vapour deposition process according to claim 3, wherein the tetraethoxysilane temperature is from 40°C to 80°C.

5. A process according to any one of the preceding claims, wherein a plurality of silicon wafers are placed in an elongated tubular deposition chamber (16), each of said silicon wafers having a pair of opposed faces, said faces of said silicon wafers being aligned substantially parallel to one another and substantially perpendicular to a long axis of said deposition chamber; evacuating said deposition chamber to a subatmospheric pressure of less than 1 torr by means of a vacuum pump (18); heating said wafers; flowing nitrogen into a means (102) for connecting said deposition chamber (16) with said vacuum pump (18); vapourising a quantity of tetraethoxysilane; flowing said vapourised tetraethoxysilane into said deposition chamber (16) while maintaining a vacuum level in said deposition chamber; and contacting said silicon wafers with said vapourised tetraethoxysilane to deposit a thin film of silicon dioxide thereon.

6. A chemical vapour deposition process according to claim 1 for depositing a thin oxide film on at least one silicon wafer in the deposition chamber at the preselected second vacuum level and reactant gas flow rate, comprising the steps of:
   evacuating the deposition chamber (16) by the vacuum pumping means (18);
   flowing the inert gas into the vacuum pumping means (18) at a first flow rate for establishing the preselected second vacuum level;
   determining a second inert gas flow rate from the difference between the first inert gas flow rate and the preselected reactant gas flow rate;
   flowing inert gas into the process downstream of the deposition chamber (16) at the second inert gas flow rate;
   flowing reactant gas into the deposition chamber (16) at the preselected flow rate; and
   contacting the silicon wafer with reactant gas to deposit a thin film of oxide thereon.

7. A chemical vapour deposition process according to claim 6, wherein said inert gas is nitrogen.

8. A chemical vapour deposition process according to claim 6 or 7, wherein said reactant gas is tetraethoxysilane.

9. A chemical vapour deposition process according to claim 6, 7 or 8, wherein the preselected operating pressure is maintained by controlling the flow of reactant gas into the deposition chamber (16).

10. A chemical vapour deposition process according to claim 9, wherein the reactant gas flow rate is controlled by a motorised plug valve (90) in response to the pressure in the deposition chamber (16).

**Revendications**

1. procédé pour le dépôt chimique en phase vapeur d'une couche mince d'oxyde déposé sur au moins un substrat en silicium, caractérisé en ce qu'il comprend les étapes de : placer au moins un substrat en silicium dans une chambre de dépôt (16) ; évacuer ladite chambre de dépôt à une pression subatmosphérique par un moyen (18) pour le pompage sous vide ; chauffer ledit substrat ; faire

6

s'écouler un gaz inerte dans un moyen (102) reliant ladite chambre de dépôt (16) audit moyen (18) pour pomper à vide afin d'établir un premier niveau de vide dans ladite chambre de dépôt (16) ; vaporiser une source d'un liquide réactif ; faire s'écouler ledit réactif vaporisé dans ladite chambre de dépôt (16) tout en maintenant un niveau de vide dans la chambre de dépôt (16) ; et mettre ledit substrat en silicium en contact avec ladite source de réactif vaporisé pour déposer une couche mince d'oxyde sur ledit substrat en silicium.

2. Procédé de dépôt chimique en phase vapeur selon la revendication 1, où le second niveau de vide dans la chambre de dépôt est maintenu en contrôlant l'écoulement du réactif vaporisé.

3. Procédé de dépôt chimique en phase vapeur selon la revendication 1 ou 2, où la source de liquide réactif est le tétraéthoxysilane.

4. Procédé de dépôt chimique en phase vapeur selon la revendicaiton 3, où la température du tétraéthoxysilane est comprise entre 40°C et 80°C.

5. Procédé selon l'une quelconque des revendications précédentes, où on place un certain nombre de substrats en silicium dans une chambre tubulaire et allongée de dépôt (16), chacun desdits substrats en silicium ayant une paire de faces opposées, lesdites faces desdits substrats en silicium étant sensiblement alignées parallèlement les unes aux autres et sensiblement perpendiculairement à l'axe long de ladite chambre de dépôt ; on évacue ladite chambre de dépôt jusqu'à une pression subatmosphérique de moins de 1 torr au moyen d'une pompe à vide (18) ; on chauffe lesdits substrats ; on fait s'écouler de l'azote dans un moyen (102) pour connecter ladite chambre de dépôt (16) à ladite pompe à vide (18) ; on vaporise une quantité de tétraéthoxysilane ; on fait s'écouler ledit tétraéthoxysilane vaporisé dans ladite chambre de dépôt (16) tout en maintenant un niveau de vide dans ladite chambre de dépôt ; et on met lesdits substrats en silicium en contact avec ledit tétraéthoxysilane vaporisé pour y déposer un film mince de bioxyde de silicium.

6. Procédé de dépôt chimique en phase vapeur selon la revendication 1, pour déposer une couche mince d'oxyde sur au moins un substrat en silicium dans la chambre de dépôt au second niveau présélectionné de vide et débit de gaz réactif, comprenant les étapes de :
   évacuer la chambre de dépôt (16) par le moyen de pompage à vide (18) ;
   faire s'écouler le gaz inerte dans le moyen de pompage à vide (18) à un premier débit pour établir le second niveau présélectionné de vide ;
   déterminer un second débit de gaz inerte à partir de la différence entre le premier débit de gaz inerte et le débit présélectionné de gaz réactif ;
   faire s'écouler le gaz inerte dans le procédé en aval de la chambre de dépôt (16) au second débit de gaz inerte ;
   faire s'écouler le gaz réactif dans la chambre de dépôt (16) au débit présélectionné ; et
   mettre le substrat en silicium en contact avec le gaz réactif pour y déposer une couche mince d'oxyde.

7. Procédé de dépôt chimique en phase vapeur selon la revendication 6, où ledit gaz inerte est de l'azote.

8. Procédé de dépôt chimique en phase vapeur selon la revendication 6 ou 7, où ledit gaz réactif est du tétraéthoxysilane.

9. Procédé de dépôt chimique en phase vapeur selon la revendication 6, 7 ou 8, où la pression présélectionnée de fonctionnement est maintenue en contrôlant l'écoulement du gaz réactif dans la chambre de dépôt (16).

10. Procédé de dépôt chimique en phase vapeur selon la revendication 9, où le débit de gaz réactif est contrôlé par une vanne motorisée à pointeau (90) en réponse à la pression dans la chambre de dépôt (16).

**Patentansprüche**

1. Verfahren zum chemischen Aufdampfen einer dünnen Oxidschicht auf ein Siliziumsubstrat, gekennzeichnet durch die Schritte: Anordnen mindestens eines Siliziumsubstrats in einer Aufdampfkammer (16); Evakuieren dieser Aufdampfkammer auf einen unteratmosphärischen Druck mit einer Vakuumpumpe (18); Erhitzen des Substrats; Einleiten eines Inertgases in eine die Aufdampfkammer (16) mit der Vakuumpumpe (18) verbindende Einrichtung, um in der Aufdampfkammer (16) eine erste Unterdruckhöhe zu erzeugen; Verdampfen eines in flüssiger Form vorliegenden Verbrennungshilfsstoffes; Einleiten des verdampften Verbrennungshilfsstoffes in die Aufdampfkammer (16), während in der Aufdampfkammer (16) eine zweite Unterdruckhöhe aufrechterhalten wird; und in Berührung bringen des Siliziumsubstrats mit dem verdampften Verbrennungshilfsstoff, um eine dünne Oxidschicht auf das Siliziumsubstrat aufzudampfen.

2. Verfahren zum chemischen Aufdampfen nach Anspruch 1, wobei das zweite Unterdruckniveau in der Aufdampfkammer durch Steuern der Strömung des verdampften Verbrennungshilfsstoffes beibehalten wird.

3. Verfahren zum chemischen Aufdampfen nach Anspruch 1 oder 2, wobei der in flüssiger Form vorliegende Verbrennungshilfsstoff Tetraethoxysilan ist.

4. Verfahren zum chemischen Aufdampfen nach Anspruch 3, wobei das Tetraethoxysilan eine Temperatur von 40° bis 80°C hat.

5. Verfahren nach einem der vorhergehenden Ansprüche, wobei mehrere Siliziumsubstrate in einer länglichen rohrförmigen Aufdampfkammer (16) angeordnet werden, wobei jedes Siliziumsubstrat zwei gegenüberliegende Flächen hat, die zueinander im wesentlichen parallel sind und im wesentlichen rechtwinklig zur Längsachse der Aufdampfkammer angeordnet werden; Evakuieren der Aufdampfkammer auf einen unteratmosphärischen Druck von weniger als 1 torr mittels einer Vakuumpumpe (18); Erhitzen der Substrate; Einleiten von Stickstoff in eine die Aufdampfkammer (16) mit der Vakuumpumpe (18) verbindende Einrichtung (102); Verdampfen einer Menge von Tetraethoxysilan; Einleiten des verdampften Tetraethoxysilans in die Aufdampfkammer (16), während eine Unterdruckhöhe in der Aufdampfkammer beibehalten wird; und in Berührung bringen der Siliziumsubstrate mit dem verdampften Tetraethoxysilan, um eine dünne Schicht aus Siliziumdioxid auf diese aufzudampfen.

6. Verfahren nach Anspruch 1 zum chemischen Aufdampfen einer dünnen Oxidschicht auf mindestens ein Siliziumsubstrat in der Aufdampfkammer bei der vorbestimmten zweiten Unterdruckhöhe und der Gasströmung des Verbrennungshilfsstoffes, umfassend die Schritte:
Evakuieren der Aufdampfkammer (16) mittels der Vakuumpumpe (18);
Einleiten des Intertgases in die Vakuumpumpe (18) mit einer ersten Strömungsgeschwindigkeit zur Errichtung der vorbestimmten zweiten Unterdruckhöhe;
Bestimmen einer zweiten Strömungsgeschwindigkeit des Intertgases aus dem Unterschied zwischen der ersten Strömungsgeschwindigkeit des Intertgases und der vorgegebenen Strömungsgeschwindigkeit des Verbrennungshilfsgases;
Einleiten von Intertgas in den Prozeß stromabwärts von der Aufdampfkammer (16) mit der zweiten Strömungsgeschwindigkeit des Intertgases;
Einleiten des Verbrennungshilfsgases in die Aufdampfkammer (16) mit der vorgegebenen Strömungsgeschwindigkeit; und
in Berührung bringen der Siliziumsubstrate mit dem Verbrennungshilfsgas, um einen dünnen Oxidfilm auf diese aufzudampfen.

7. Verfahren zum chemischen Aufdampfen nach Anspruch 6, wobei das Inertgas Stickstoff ist.

8. Verfahren zum chemischen Aufdampfen nach Anspruch 6 oder 7, wobei das Verbrennungshilfsgas Tetraethoxysilan ist.

9. Verfahren zum chemischen Aufdampfen nach Anspruch 6, 7 oder 8, wobei der vorgegebene Betriebsdruck durch Steuern der Strömungsgeschwindigkeit des Verbrennungshilfsgases in die Aufdampfkammer (16) beibehalten wird.

10. Verfahren zum chemischen Aufdampfen nach Anspruch 9, wobei die Strömungsgeschwindigkeit des Verbrennungshilfsgases in Abhängigkeit vom Druck in der Aufdampfkammer (16) mit einem motorgetriebenen Absperrventil (90) gesteuert wird.

Fig.1.

# Fig.2.